**Europäisches Patentamt**

**European Patent Office**

**Office européen des brevets**

(19)

(11) Publication number : **0 293 144 B1**

# (12) EUROPEAN PATENT SPECIFICATION

(45) Date of publication of patent specification :
**19.02.92 Bulletin 92/08**

(51) Int. Cl.$^5$ : **H01S 3/133, H01S 3/025**

(21) Application number : **88304622.9**

(22) Date of filing : **20.05.88**

(54) **Semiconductor laser apparatus.**

(30) Priority : **27.05.87 JP 130368/87**

(43) Date of publication of application :
**30.11.88 Bulletin 88/48**

(45) Publication of the grant of the patent :
**19.02.92 Bulletin 92/08**

(84) Designated Contracting States :
**DE FR GB NL**

(56) References cited :
**EP-A- 0 162 668**
**EP-A- 0 194 835**
**EP-A- 0 206 661**
**DE-A- 3 533 465**
**GB-A- 2 052 841**
**US-A- 4 599 729**

(73) Proprietor : **SONY CORPORATION**
**7-35 Kitashinagawa 6-Chome Shinagawa-ku**
**Tokyo 141 (JP)**

(72) Inventor : **Okada, Tsunekazu c/o Patents**
**Division**
**Sony Corporation 6-7-35 Kitashinagawa**
**Shinagawa-ku Tokyo 141 (JP)**
Inventor : **Yamaguchi, Nozomu c/o Patents**
**Division**
**Sony Corporation 6-7-35 Kitashinagawa**
**Shinagawa-ku Tokyo 141 (JP)**

(74) Representative : **Cotter, Ivan John et al**
**D. YOUNG & CO. 10 Staple Inn**
**London WC1V 7RD (GB)**

EP 0 293 144 B1

## Description

This invention relates to semiconductor laser apparatus.

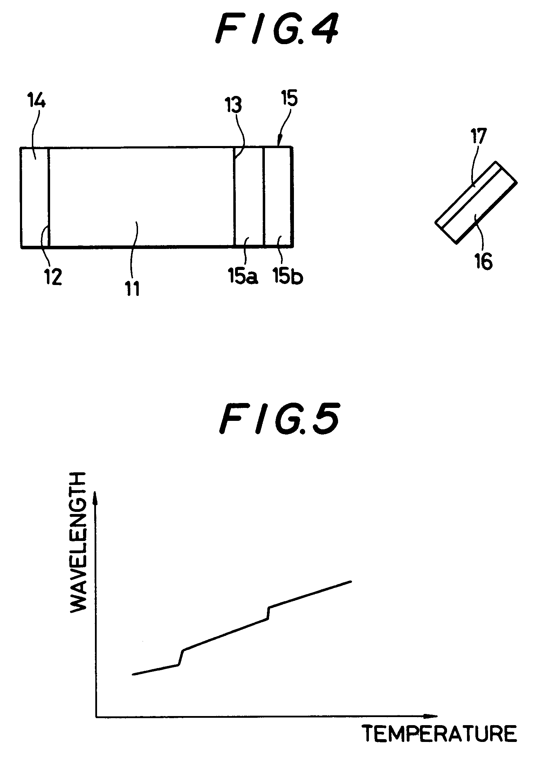

Figure 4 of the accompanying drawings shows a previously proposed semiconductor laser apparatus which detects a laser beam from a semiconductor laser element 11 using a monitor light-receiving element 16 so as to perform automatic light power control. The semiconductor laser element 11 has an output end face 12 for emitting output light and an output end face 13 for emitting monitor light.

An end face protection film 14 (which is an Al$_2$O$_3$ film) is formed on the output end face 12 and an end face protection film 15 (consisting of or including an Al$_2$O$_3$ film 15a and an amorphous Si film 15b) is formed on the output end face 13.

The monitor light-receiving element 16 is arranged obliquely with respect to the semiconductor laser element 11 at the side of the output end face 13 of the element 11. A surface protection film 17 is formed on a light-receiving surface of the light-receiving element 16.

The light-receiving element 16 is arranged obliquely so as to prevent monitor light reflected by the light-receiving element 16 from returning to the semiconductor laser element 11.

The wavelength of the laser beam emitted from the semiconductor laser element 11 has a temperature dependency of about 2.5 Angstroms per degree, as shown in Figure 5 of the accompanying drawings. If the light-receiving element 16 is arranged obliquely as described above, the reflectivity of the surface protection film 17 will differ in dependence on the wavelength of the incident light. Therefore, the detection power of the light-receiving element 16 also has a temperature dependency.

The temperature dependency of the detection power of the light-receiving element 16 may be positive or negative with respect to a change in temperature, depending on individual light-receiving elements 16.

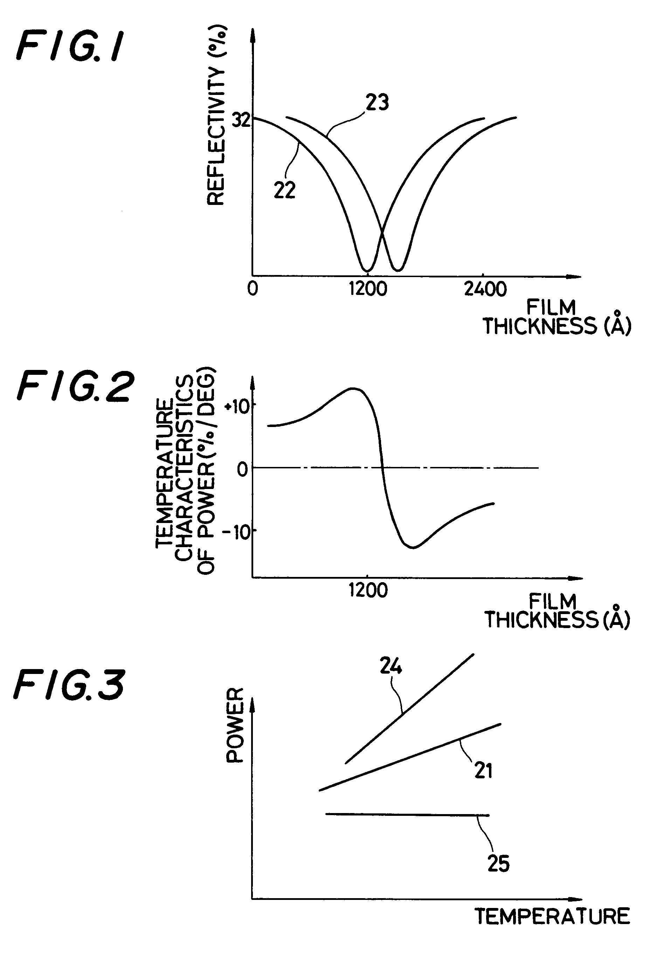

Assuming that the temperature dependency of the detection power of the light-receiving element 16 is positive with respect to a change in temperature, then, even if the power of the semiconductor laser element 11 is constant, the detection power of the light-receiving element 16 is increased as the temperature increases, as represented by a line 21 (detection power/temperature characteristic) in Figure 3 of the accompanying drawings, which is a power/temperature graph.

The reflectivities of the end face protection films 14 and 15 of the semiconductor laser element 11 change in accordance with their thicknesses. Figure 1 of the accompanying drawings shows the relationship between the thickness of the Al$_2$O$_3$ film and the reflectivity. Note that the reflectivity when the thickness is zero is equal to that of GaAs, which constitutes the semiconductor laser element 11.

As can be seen from Figure 1, for example, a reflectivity represented by a curve 22 becomes at a minimum when the film thickness is about 1200 Angstroms, and is such as to have an identical value for two different film thicknesses. In a previously proposed apparatus, in order to obtain a desired reflectivity, the thickness of the Al$_2$O$_3$ film is set to be less than 1200 Angstroms.

The reflectivity of Al$_2$O$_3$ also changes in accordance with the wavelength of the incident light. The reflectivity curve 22 corresponds to incident light having a wavelength of 790 nm. A reflectivity curve 23 corresponds to incident light having a wavelength of 800 nm. For this reason, the power of the semiconductor laser element 11 on which the end face protection films 14 and 15 are formed also has a temperature dependency.

Since the end face protection film 15 comprises the amorphous Si film 15b in addition to the Al$_2$O$_3$ film 15a, in order to increase the ratio of a laser beam emitted from the output end face 12, and thus has a higher reflectivity than that of the end face protection film 14, it has a smaller temperature dependency than the end face protection film 14.

Therefore, if a current is supplied to the semiconductor laser element 11 to obtain a constant power of the output light emitted from the output end face 12, the power of the monitor light emitted from the output end face 13 has a temperature dependency with respect to the thickness of the end face protection film 14, as shown in Figure 2 of the accompanying drawings.

Since the thickness of the Al$_2$O$_3$ film constituting the end face protection film 14 is less than 1200 Angstroms, as mentioned above, the temperature dependency of the power of the semiconductor laser element 11 is positive with respect to a change in temperature, as can be seen from Figure 2.

As a result, the temperature dependency of the power of the semiconductor laser element 11 is superposed on that of the light-receiving element 16 as represented by the line 21 in Figure 3. Therefore, the power of the semiconductor laser apparatus, as represented by a line 24 in Figure 3, has a very large temperature dependency.

In the semiconductor laser apparatus according to the invention, each end face protection film of a semiconductor laser element has a thickness such that the temperature dependency of the power of the laser beam transmitted through the end face protection film and the temperature dependency of a detection power of an output control light-receiving element have inverse characteristics to each other.

As a result, the temperature dependencies at least partially cancel each other, whereby variation of the power of the output light due to a change in temperature can be minimised.

The invention will now be further described, by way of illustrative and non-limiting example, with reference to the accompanying drawings, in which:

Figure 1 is a graph showing the reflectivity of an end face protection film of a semiconductor laser element;

Figure 2 is a graph showing temperature characteristics of the power of monitor light of the semiconductor laser element;

Figure 3 is a graph showing temperature characteristics of the semiconductor laser element and a light-receiving element;

Figure 4 is a schematic side view of a semiconductor laser apparatus; and

Figure 5 is a graph showing the relationship between the wavelength of a laser beam and temperature.

A semiconductor laser apparatus embodying the invention will now be described with reference to Figures 1 and 4. The apparatus embodying the invention is of substantially the same arrangement as the previously proposed apparatus shown in and described with reference to Figure 4, except that the end face protection film 14 and the $Al_2O_3$ film 15a of the semiconductor laser element 11 have the same reflectivity as that in the previously proposed apparatus but have a thickness of greater than 1200 Angstroms.

In this embodiment, as can be seen from Figures 1 and 2, the temperature dependency of the power of the semiconductor laser element 11 is negative with respect to a change in temperature.

Therefore, as shown in Figure 3, even if the temperature dependency (as represented by the line 21) of the light-receiving element 16 is the same as that in the previously proposed apparatus, the temperature dependency (as represented by the line 21) of the light-receiving element 16 cancels that of the power of the semiconductor laser element 11.

As a result, the temperature dependency of the semiconductor laser apparatus according to this embodiment, as represented by a line 25 in Figure 3, is very small.

## Claims

1. A semiconductor laser apparatus comprising:
a semiconductor laser element (11) which has first and second output end faces (12, 13) on which end face protection films (14, 15) are formed, and which is operative to produce output light in the form of a laser beam emitted from the first output end face (12); and
a light-receiving element (16) for detecting a laser beam emitted from the second output end face (13) in order to control the power of the output light, the light receiving element being at an angle to the emitted beam and having a protective film (17), characterised in that each of the end face protection films (14, 15) has a thickness such that the temperature dependency of the power of the laser beam transmitted through said end face protection film and the temperature dependency of a detection power of the light-receiving element (16) have inverse characteristics to each other.

2. Apparatus according to claim 1, wherein the end face protection film (14) formed on the first output end face (12) comprises an $Al_2O_3$ film and the end face protection film (15) formed on the second output end face (13) comprises a two-layered film formed by an $Al_2O_3$ film (15a) and an amorphous Si film (15b).

3. Apparatus according to claim 2, wherein the thickness of at least one of said $Al_2O_3$ films is greater than 120 nm (1200 Angstroms).

## Patentansprüche

1. Halbleiterlaservorrichtung mit:
einem Halbleiterlaserelement (11), welches eine erste und zweite Ausgangsendfläche (12, 13), auf welchen Endflächenschutzfilme (14, 15) ausgebildet sind, aufweist, und welches zur Erzeugung von Ausgangslicht in Form eines von der ersten Ausgangsendfläche (12) emittierten Laserstrahls betreibbar ist, und einem Lichtempfangselement (16) zum Detektieren eines von der zweiten Ausgangsendfläche (13) emittierten Laserstrahls, um die Leistung des Ausgangslichts zu steuern, wobei das Lichtempfangselement in einem Winkel zum emittierten Strahl ist und einen Schutzfilm (17) aufweist, **dadurch gekennzeichnet,** daß jeder der Endflächenschutzfilme (14, 15) eine solche Dicke aufweist, daß die Temperaturabhängigkeit der Leistung des durch den Endflächenschutzfilm transmittierten Laserstrahls und die Temperaturabhängigkeit einer Detektionsleistung des Lichtempfangselements (16) zueinander inverse Charakteristiken aufweisen.

2. Vorrichtung nach Anspruch 1, wobei der auf der ersten Ausgangsendfläche (12) ausgebildete Endflächenschutzfilm (14) einen $Al_2O_3$-Film und der auf der zweiten Ausgangsendfläche (13) ausgebildete Endflächenschutzfilm (15) einen durch einen $Al_2O_3$-Film (15a) und einen amorphen Si-Film (15b) gebildeten zweischichtigen Film aufweist.

3. Vorrichtung nach Anspruch 2, wobei die Dicke wenigstens eines der $Al_2O_3$-Filme größer als 120 nm (1200 Angström) ist.

## Revendications

1. Appareil à laser à semi-conducteurs comprenant :
un élément à laser à semi-conducteurs (11) qui comporte des première et seconde faces extrêmes de sortie (12, 13) sur lesquelles sont formés des films de protection de face extrême (14, 15), et qui est capable de produire une lumière de sortie sous forme d'un rayon laser émis depuis la première face extrême de sortie (12) ; et un élément récepteur de lumière (16) destiné à détecter un rayon laser émis depuis la seconde face extrême de sortie (13) afin de commander la puissance de la lumière de sortie, l'élément récepteur de lumière étant incliné par rapport au rayon émis et comportant un film protecteur (17), caractérisé en ce que chacun des films de protection de face extrême (14, 15) a une épaisseur telle que la dépendance vis-à-vis de la température de la puissance du rayon laser transmis à travers ledit film de protection de face extrême et la dépendance vis-à-vis de la température de la puissance de détection de l'élément récepteur de lumière (16) ont des caractéristiques inverses les unes des autres.

2. Appareil selon la revendication 1, dans lequel le film de protection de face extrême (14) formé sur la première face extrême de sortie (12) comprend un film de $Al_2O_3$, et le film de protection de face extrême (15) formé sur la seconde face extrême de sortie (13) comprend un film de couche formé par un film de $Al_2O_3$ (15a) et par un film de Si amorphe (15b).

3. Appareil selon la revendication 2, dans lequel l'épaisseur d'au moins desdits films de $Al_2O_3$ est supérieure à 120 nm (1 200 Å).

*FIG.1*

REFLECTIVITY (%)

32

23

22

0          1200          2400

FILM
THICKNESS (Å)

*FIG.2*

TEMPERATURE CHARACTERISTICS OF POWER (%/DEG)

+10

0

-10

1200

FILM
THICKNESS (Å)

*FIG.3*

POWER

24

21

25

TEMPERATURE

# FIG.4

# FIG.5